# EUROPEAN PATENT SPECIFICATION

(11) **EP 1 587 057 B1**
(45) Date of publication and mention of the grant of the patent: **19.03.2014**
(21) Application number: 05102975.9
(22) Date of filing: 14.04.2005
(51) Int. Cl.: G09G 3/32

(54) **Bistable electroluminescent panel with three electrode arrays**
Bistabile elektrolumineszente Anzeigetafel mit drei Sätzen von Elektroden
Panneau électroluminescent bistable à trois réseaux d'électrodes

(30) Priority: 16.04.2004 FR 0404037
(43) Date of publication of application: 19.10.2005
(73) Proprietor: Thomson Licensing, 92130 Issy-les-Moulineaux (FR)
(72) Inventor: Fery, Christophe, 35000 Rennes (FR); Dagois, Jean-Paul, 35510 Cesson Sévigné (FR)
(74) Representative: Browaeys, Jean-Philippe

(56) References cited:
- EP-A- 1 246 157
- US-A- 5 055 739
- US-A1- 2002 043 927

## Description

The invention relates to a bistable electroluminescent panel for displaying images comprising, disposed on a substrate:
- an array of electroluminescent cells and an array of bistable elements, each associated with a cell and provided with control means,
- an array of electrodes used only for power supply,
- and an array of electrodes used both for addressing and for power supply and extending transversally to the electrodes of the other array,
in which each electroluminescent cell is linked in series with the bistable element which is associated with it between an electrode of one of the power supply arrays and an electrode of the other power supply array.

Active matrix electroluminescent panels comprising an array of electroluminescent cells disposed on an array of pixel control circuits etched in a semiconductor substrate, for example based on polycrystalline silicon, are known; each pixel circuit normally comprises, to control the associated cell, a current modulator in series with that cell; the terminals of this series are each linked to a power supply electrode of each array; the pixel circuit is also provided with a scanning electrode intended to activate this circuit, and a data electrode linked to the setpoint of the current modulator and intended for addressing video data to the cell. Thus, for each pixel, there are four electrodes: two power supply electrodes, one scanning electrode and one data electrode. These panels therefore normally comprise at least four electrode arrays.

Also known are "bistable" electroluminescent panels, with passive matrix, in which each pixel comprises an electroluminescent cell and a bistable element in series; this series is connected between two electrodes which are used both for driving and power supply purposes, as, for example, described in documents WO03/012869 and WO03/054843. These panels are therefore provided with only two electrode arrays.

Depending on the voltage signal applied to each series, the bistable element of each pixel:
- can be switched from a stable high impedance "off" state to a stable low impedance "on" state in response to a selective activation voltage addressing signal, or vice versa in response to an erase voltage addressing signal,
- and can be maintained in the off or on state in which it has been set by this addressing signal, by applying a "sustain" voltage which is the same for all the cells of the panel.

US documents 4035774 - IBM, 4808880 - CENT, 6188175 B1 - CDT, WO03/012869, WO03/054843 and 5055739 describe panels of this type, in which each pixel comprises an organic electroluminescent layer and a stacked photoconductive layer; the photoconductive layer forms the bistable element of the pixel.

Other bistable elements can be envisaged such as n-p-n-p junctions as described, for example, in documents FR2846794 or such as organic layers as described for example in document US2002-190664.

Document US2002/0043927 describes a photoconductive effect-based bistable electroluminescent panel, in which the switching of the photoconductive bistable elements is generated by the emission of electroluminescent cells specifically dedicated to addressing, disposed on the back of the panel (referenced 57); each addressing electroluminescent cell is optically coupled, via an insulating layer referenced 44, with a bistable element of the photoconductive layer referenced 51; thus, each addressing electroluminescent cell controls the ON or OFF state of each pixel of the panel. There are therefore four electrode arrays: two arrays for powering the addressing electroluminescent cells and two arrays for powering the main electroluminescent cells.

Document JP11-154597 also describes a photoconductive effect-based bistable electroluminescent panel provided with four electrode arrays: with reference to Figures 4 and 5 of this document, at each pixel, the electroluminescent layer referenced 20 is subdivided into an area intended for addressing between two addressing electrodes 17 and 24 intersecting in this addressing area and a main emission area in series with a photoconductive element 14, this series being powered between two power supply electrodes 12 and 22 intersecting in this main emission area; the photoconductive element 14 is disposed close to the electroluminescent area intended for addressing, to obtain an optical coupling; as for document US2002/0043927, there are therefore two arrays of addressing electrodes and two arrays of power supply electrodes.

The problem with photoconductive effect-based bistable electroluminescent panels with two electrode arrays as described in the abovementioned documents WO03/012869 and WO03/054843 is that the capacitive losses in the pixel addressing sequences are very high.

In practice, if the vertical electrodes of one of the arrays are called columns and the horizontal electrodes of the other array are called rows, the capacitive loss for a column can be expressed as: E = C.Va².N.f.s, in which C is the capacitance between electrodes at an intersection of a row and a column, N is the number of rows, Va is the addressing voltage, f is the frame frequency, s is the number of subframes in each frame.

Since the electrodes are also used for power supply purposes, they present a surface area that is big enough to transfer to the cells the electrical power supply with no loss of charge, and the capacitance C is therefore high, which causes high capacitive losses.

The problem with photoconductive effect-based bistable electroluminescent panels with four electrode arrays as described in the abovementioned documents US2002/0043927 and JP11-154597 is their complexity associated, in particular, with the number of electrode arrays, the complexity being economically disadvantageous.

Document EP1246157 describes an active matrix electroluminescent panel; each cell has a corresponding pixel circuit which is incorporated in the active matrix and which comprises a bistable element (in this case, the "memory" element referenced 10) linked in series with an electroluminescent cell (ref. 8) and control means represented here by a transistor (ref. 3). This panel has four electrode arrays: two arrays used only for powering the cells (referenced 6 and 7), one array (ref. 4) used to control the control means (ref. 3) and one array used for addressing (ref. 5). Three of these four arrays must be incorporated in the active matrix. The need, in this case, to incorporate three electrode arrays in the active matrix is economically disadvantageous, even in terms of light performance of the panel.

One object of the invention is to avoid the abovementioned problems by proposing bistable electroluminescent panels, in particular based on photoconductive effect, with only three electrode arrays in total.

To this end, the object of the invention is to produce an image display device comprising a bistable electroluminescent panel according to claim 1.

According to the invention, the same electrode is used both to control the bistable element control means and to power the electroluminescent cells corresponding to these elements. By applying, for example, the invention to the panel described in Figure 1 in the abovementioned document EP1246157, the scanning electrode 4, which controls the control means represented by the transistor 3, and the power supply electrode 6 form only one and the same electrode. The number of electrode arrays of the panel is thus advantageously limited compared to the four arrays described in that document.

Preferably, the electrodes Aₚ of the array used mainly for addressing are narrower than the electrodes Xₚ of the first power supply array. The capacitive losses in the addressing phases of the panel are thus limited without increasing the charge losses on the cell power supply circuit.

Preferably, these addressing electrodes are at least two times narrower than the power supply electrodes, which means that the capacitive losses are more significantly limited.

Preferably, each electroluminescent cell C_{n,p} is linked in series with the bistable element B_{n,p} which is associated with it using an electrode forming an intermediate layer. The intermediate electrodes of the various cells are electrically insulated from each other; they are normally floating.

Preferably, said intermediate electrode is transparent or semi-transparent and the bistable element associated with this cell comprises a photoconductive layer which is inserted between said intermediate layer and the electrode Xₚ used only for powering said cell. Thus, each pixel of the panel comprises an electroluminescent layer element and a photoconductive layer element with an intermediate electrode between these two layer elements; because of the transparency of the intermediate electrode, immediately the bistable element is switched to the on state using the control means of this element, the electroluminescent layer element emits light which, through the transparent intermediate electrode, maintains the low impedance state and therefore the on state of the photoconductive layer element.

Preferably, for each electroluminescent cell C_{n,p}, the means of controlling the associated bistable element comprise an addressing electroluminescent layer which is inserted between the electrode Aₚ used mainly for addressing said cell and the electrode Yₙ used both for addressing and for power supply, and which is optically coupled with the photoconductive layer of said bistable element.

Preferably, each electroluminescent cell C_{n,p} comprises a main electroluminescent layer which forms one and the same layer with the electroluminescent layer addressing the control means of the bistable element of said cell. The optical coupling between the electroluminescent layer and the photoconductive layer is then provided through the transparent or semi-transparent intermediate electrode.

Preferably, all the electrodes Xₚ used only for power supply are interlinked at the same potential.

Another object of the invention is to produce an image display device comprising a panel according to the invention.

The invention will be better understood from reading the description that follows, given by way of nonlimiting example, and with reference to the appended figures, in which:
- Figure 1 is a diagrammatic plan view of a panel according to an embodiment of the invention, which illustrates the three electrode arrays specific to the invention,
- Figure 2 is a cross-sectional view through AA' of Figure 1 of a pixel of the panel of Figure 1,
- Figure 3 is a variant of the structure of Figure 2, which corresponds to a second embodiment of the invention,
- Figure 4 represents timing diagrams of voltage signals applied to drive the panel according to the embodiment of Figure 1.

The figures representing timing diagrams do not take into account the scale of values in order to better represent certain details that would not be clearly apparent if the proportions were respected.

To simplify the description, identical or similar references are used for elements that provide the same functions.

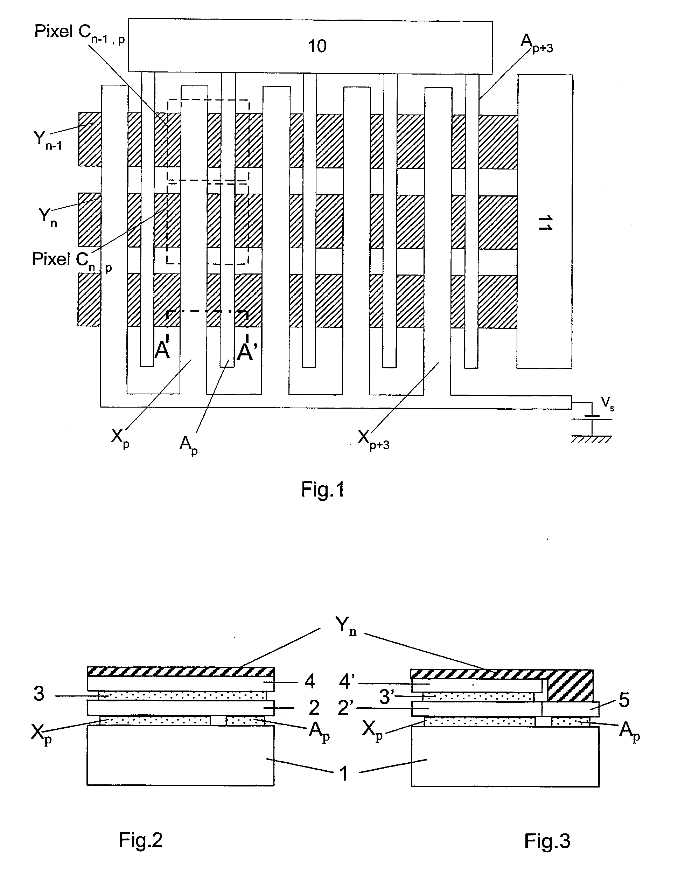

Referring to Figures 1 and 2, the panel according to the invention comprises a substrate 1 which directly supports two arrays of electrodes, the first power supply array Xₚ intended to be used only to power the cells, and an array Aₚ intended to be used mainly for addressing. The electrodes of these two arrays are parallel, extending vertically and are therefore named "columns". The power supply electrodes Xₚ are substantially wider than the addressing electrodes Aₚ, preferably at least twice as wide. Between two adjacent addressing electrodes, there is a power supply electrode Xₚ, and vice versa. According to a variant that is not represented, each power supply electrode Xₚ is subdivided into two electrodes Xₚₐ, X_{pb} and each addressing electrode Ap is positioned between two subdivided electrodes Xpₐ, X_{pb}.

These two electrode arrays directly support a photoconductive layer 2, which itself supports transparent intermediate electrodes 3, which in turn support an organic electroluminescent layer 4, which itself supports the second power supply array Yₙ, the electrodes of which extend perpendicularly to the electrodes Xₚ and Aₚ of the other arrays. These electrodes Yₙ are used both for addressing and for power supply.

At each intersection of an electrode Xₚ and an adjacent electrode Aₚ with an electrode Yₙ there is an electroluminescent cell C_{n,p} of the panel, a cross section of which is represented in Figure 2. This electroluminescent cell comprises a portion of organic electroluminescent layer 4. The portion of the photoconductive layer 2 situated under this portion of organic electroluminescent layer 4 forms a bistable element B_{n,p} associated with this cell. The series formed by the electroluminescent cell C_{n,p} and this bistable element B_{n,p} is linked between the electrode Xₚ and the electrode Yₙ at the intersection of which this cell is located. The intermediate electrodes 3 of the various pixels of the panel are electrically insulated from each other; these electrodes are floating.

At the intersection of the electrode Aₚ adjacent to the electrode Xₚ with the same electrode Yₙ are located the control means of the bistable element B_{n,p}. These control means are here formed by the same electroluminescent 4 and photoconductive 2 layers with, inserted between them, the intermediate electrode 3. A variant concerning these control means will be described later.

Since the intermediate electrodes are transparent, there is an optical coupling between the control means and the bistable elements; when the portion of electroluminescent layer located at the intersection of the electrode Aₚ with the electrode Yₙ produces light following the application of an appropriate addressing voltage signal between these electrodes, this produced light passes through the transparent electrode 3 to the photoconductive layer 2 which then switches to a low impedance state, thus causing the state of the bistable element B_{n,p} to switch over; the power supply voltage applied between the electrodes Xₚ and Yₙ is then relayed to the terminals of the cell C_{n,p} which then emits the light.

The fabrication of the panel according to the invention that has just been described will not be given here in detail; it involves means and methods that are intrinsically known.

There now follows a description of a display device provided with such a panel and, by way of nonlimiting example, a method of driving this panel.

With reference to Figure 1, this device therefore comprises the panel which has just been described, means 10 of controlling the addressing electrodes Aₚ, means 11 of controlling the row electrodes Yₙ, used both for addressing and for power supply; these control means 10 and 11, called "driver" in English, are designed to send to the electrodes power supply voltage, select or addressing signals which will be described later and which are generated by means that are not represented.

With reference to Figure 1, all the electrodes Xₚ of the array used only for power supply are linked to each other and to the means of powering the panel which deliver the same power supply voltage Vₛ to these electrodes.

To drive the panel so as to display a succession of image frames, each frame being broken down into subframes according to the number of bits required to encode the grey scales of the images, the procedure is as follows: for the duration of each subframe, using means 11 of controlling the row electrodes Yₙ, each row electrode Yₙ of the panel is selected in turn.

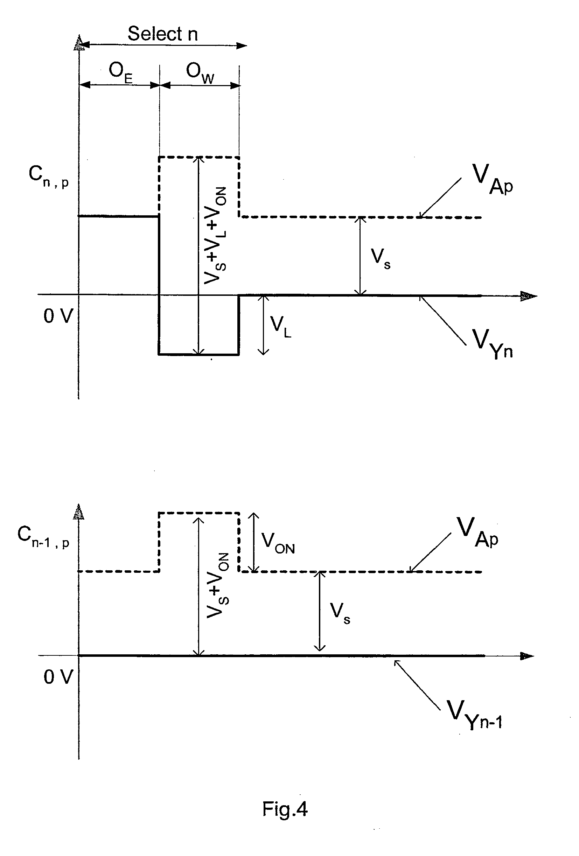

As represented at the top of Figure 4, the selection of each row n comprises two operations:
- firstly, an erase operation O_{E} designed to switch to the high impedance OFF state all the bistable elements of the cells C_{n,p} of this row without the state of the bistable elements of the cells of the other rows being affected;
- then, a write operation O_{w}, designed to switch to the low impedance ON state the bistable elements of the cells C_{n,p} of this row which must be activated to display the image of the current subframe, and maintain the OFF state of the bistable elements of the other cells of this row which are not to be activated to display the image of the current subframe, again without the state of the bistable elements of the cells of the other rows being affected.

Figure 4 represents the timing diagrams of the voltage signals applied for addressing one of the cells C_{n,p} of a row n:
- for the erase operation: the same voltage Vₛ equal to the common voltage applied to the power supply columns Xₚ is applied to the row n and to all the addressing electrodes Aₚ; the voltage applied to the other rows, including the row n-1, is maintained at 0 V. All the cells of the row n are then off and the cells of the other rows continue to be powered by the potential difference V_{S} between the power supply electrodes Xₚ at the potential V_{S} and the row electrodes such as Yₙ₋₁ at the potential 0 V.
- during the write operation, a negative amplitude voltage V_{L} is applied to the selected row n; to activate a cell C_{n,p} of this row, a voltage V_{S} + V_{ON} is applied to the addressing electrode Aₚ which corresponds to it; so as not to activate a cell C_{n,p} of this row, the addressing electrode Aₚ which corresponds to it is maintained at the potential of the preceding operation Vₛ (not represented).

This row n selection phase is followed by other row selection phases, and normally a general maintenance phase during which, still during the same image subframe, the voltage applied to the row n is maintained at the level 0 V; because of this, the potential difference between the electrodes powering the pixels of this row is then sustained at the value Vₛ so as to power the activated cells of this row for the duration of the image subframe.

All of these voltage signals are applied in a manner known per se using the control means 10 and 11 described previously.

To obtain the ON or OFF states, it is therefore desirable for:
- a potential difference (V_{S}+V_{L}+V_{ON}) applied to a bistable element in the OFF state to switch it to the ON state: see top timing diagram of Figure 4;
- a potential difference (V_{S}+V_{ON}) applied to a bistable element in the OFF state not to switch it to the ON state: see bottom timing diagram of Figure 4.

Let V_{D} be the voltage triggering emission in the electroluminescent layer and V_{z} be the critical voltage of the photoconductive layer:
- below the threshold voltage V_{D} applied between the two layers in series, this cell therefore switches off;
- above the voltage V_{D}+V_{Z} applied between the two layers in series, this cell therefore switches on;
- for a voltage between these layers between V_{D} and V_{D}+V_{z}, the state of the cell does not change.

It is therefore desirable to choose the values of V_{S}, V_{L}, V_{ON} such that:
- V_{D} < Vₛ < V_{D}+V_{Z} and V_{D} < Vₛ+V_{ON} < V_{D}+V_{Z}
- V_{S}+V_{L}+V_{ON} > V_{D}+V_{Z}

With reference to Figure 3, there now follows a description of a variant, according to the invention, of the panel described previously.

This variant is distinguished mainly from the panel described previously in that the control means of the bistable elements are separate from the cells and bistable elements in series: in practice, in this case, an addressing electroluminescent cell formed by an electroluminescent layer 5 specific to the terminals of the addressing electrode Aₚ and of the power supply and addressing electrode Yₙ is used as a control means of the bistable element formed by the photoconductive layer 2' to which it is optically coupled, as illustrated in Figure 3. For each pixel of the panel, the area of the addressing electroluminescent layer 5 is substantially less than the area of the main electroluminescent layer 4'.

This variant is, however, more complex to produce than the embodiment described previously.

In both of the embodiments described above, the area of intersection of the addressing electrodes Aₚ with the electrodes used for power supply and addressing Yₙ is far smaller than in the bistable panels with two electrode arrays of the prior art, without this causing any increase in charge loss in the cell power supply circuit since it is independent of the addressing and has far wider electrodes Xₚ, Yₙ.

The capacitive loss for an addressing electrode Aₚ is: E = C.Va².N.f.s, in which C is the capacitance at the intersection of an addressing electrode and a row electrode, N is the number of rows, Va is the addressing voltage, equal to V_{S}+V_{L}+V_{ON}, f is the frame frequency, s is the number of subframes in each frame. Since the area of intersection is smaller than in the bistable panels with two electrode arrays of the prior art, the value of C is far smaller and the capacitive losses are reduced. Moreover, since the panels according to the invention comprise only three electrode arrays, they are simpler and less expensive to produce than the bistable panels with four electrode arrays of the prior art. The invention thus offers improved optimization.

The present invention has been described with reference to an organic electroluminescent panel with photoconductive bistable elements; to a person skilled in the art, it is obvious that it can be applied to other types of bistable electroluminescent panels without departing from the scope of the claims below.

## Claims

1. Image display device comprising a bistable electroluminescent panel for displaying images divided in sub-frames, said panel comprising, disposed on a substrate (1):
- an array of electroluminescent cells (C_{n,p}) distributed in rows and columns, and an array of bistable elements (B_{n,p}) that can be switched from a high impedance OFF state to a low impedance ON state and vice-versa wherein each bistable element (B_{n,p}) is associated with an electroluminescent cell (C_{n,p}) and is provided with control means,
- a first array of column electrodes (Xₚ) for power supplying said cells (C_{n,p}) and a second array of row electrodes (Yₙ),
- a third array of column electrodes (Aₚ) for addressing said cells (C_{n,p}),
in which each electroluminescent cell (C_{n,p}) is electrically linked in series with the bistable element (B_{n,p}) which is associated with it, which series is connected between a column electrode (Xₚ) of the first array and a row electrode (Yₙ₎ of the second array,
said image display device comprising also means for controlling the electrodes (10,11),
**characterized in that** :
- the means for controlling each bistable element (B_{n,p}) associated with an electroluminescent cell (C_{n,p}) are connected between an electrode (Aₚ) of the third array and the electrode (Yₙ₎ of said second array connecting the series linking this bistable element with its associated electroluminescent cell, the electrode (Yₙ) of said second array being thus used both for addressing and for power supply;
- the means for controlling the electrodes (10, 11) are adapted to drive said panel using only said first, second and third arrays of electrodes.

2. Image display device according to claim 1 **characterized in that** the means for controlling the electrodes (10, 11) are adapted such that, during each subframe of an image to display, a selection phase for each row of electroluminescent cells (C_{n,p}) and a subsequent maintenance phase take place, wherein each selection phase of a row of electroluminescent cells comprises an erase operation followed by a write operation, such that any erase operation is designed to switch to the high impedance OFF state all the bistable elements of the cells C_{n,p} of this row without the state of the bistable elements associated with the cells of the other rows being affected and such that any following write operation of this row of cells (Cn,p) is designed to switch to the low impedance ON state the bistable elements associated with the electroluminescent cells (Cn,p) of this row which must be activated to display the image of the current subframe, and to maintain the high impedance OFF state of the bistable elements associated with the other cells (Cn,p) of this row which are not to be activated to display the image of the current subframe, without the state ON or OFF of the bistable elements (Cn,p) of the cells of the other rows being affected.

3. Image display device according to claim 2 **characterized in that**, in order to switch to the low impedance ON state the bistable elements associated with the electroluminescent cells (C_{n,p}) of a selected row and to maintain the high impedance OFF state of the bistable elements associated with the other electroluminescent cells (C_{n,p}) of this row, the means for controlling the electrodes (10, 11) are adapted to apply a negative amplitude voltage V_{L} to this selected row electrode (Yₙ), to apply simultaneously a null voltage to the non selected row electrodes of the second array, to apply simultaneously a voltage V_{S} to the column electrodes (Xₚ) of the first array, to apply simultaneously a voltage V_{S} + V_{ON} to the electrodes (Aₚ) of the third array used for addressing the cells (C_{n,p}) that are linked to this selected row electrode (Yₙ) and that should be activated, to apply simultaneously a voltage V_{S} to the electrodes (Aₚ) of the third array used for addressing the electroluminescent cells C_{n,p} that are linked to this selected row electrode (Yₙ) and that should not be activated,
wherein, if V_{D} is the voltage triggering emission of an electroluminescent cell (C_{n,p}) and if V_{Z} is the critical voltage of a bistable element (Bₙ,ₚ) such that :
- below a voltage V_{D} applied between this electroluminescent cell (Cₙ,p) and this bistable element (B_{n,p}) in series, this electroluminescent cell switches off;
- above a voltage V_{D}+V_{Z} applied between this electroluminescent cell (C_{n,p}) and this bistable element (B_{n,p}) in series, this electroluminescent cell switches on;
- for a voltage comprised between V_{D} and V_{D}+V_{Z} applied between this electroluminescent cell (C_{n,p}) and this bistable element (B_{n,p}), the state ON or OFF of this cell does not change.
V_{S}, V_{L} and V_{ON} are chosen such that:
- V_{D} < V_{S} < V_{D}+V_{Z} and V_{D} < V_{S}+V_{ON} < V_{D}+V_{Z}
- V_{S}+V_{L}+V_{ON} > V_{D}+V_{Z}.

4. Image display device according to any one of the preceding claims, **characterized in that**, in said panel, the electrodes (Ap) of the third array are narrower than the column electrodes (Xₚ) of the first array.

5. Image display device according to any one of the preceding claims, **characterized in that**, in said panel, the electrodes (Aₚ) of the third array are at least two times narrower than the electrodes (Xₚ, Yₙ) of the first array and of the second array.

6. Image display device according to any one of the preceding claims, **characterized in that**, in said panel, each electroluminescent cell (C_{n,p}) is linked in series with the bistable element (B_{n,p}) which is associated with it using an electrode forming an intermediate layer (3).

7. Image display device according to Claim 6, **characterized in that**, in said panel, said intermediate layer (3) is transparent or semi-transparent and the bistable element (B_{n,p}) associated with this cell (C_{n,p}) comprises a photoconductive layer (2; 2') which is inserted between said intermediate layer (3) and the electrode (Xₚ) of the first array linked to this cell (C_{n,p}).

8. Image display device according to Claim 5, **characterized in that**, for each electroluminescent cell (C_{n,p}) of said panel, the means for controlling the associated bistable element (B_{n,p}) comprise an addressing electroluminescent layer (4; 5) which is inserted between the electrode (Aₚ) of the third array used for addressing said cell and the row electrode (Yₙ) of the second array linked to said cell (C_{n,p}), and which is optically coupled with the photoconductive layer (2; 2') of said bistable element (B_{n,p}).

9. Image display device according to Claim 8, **characterized in**, in said panel, that each electroluminescent cell (C_{n,p}) comprises a main electroluminescent layer (4) which forms one and the same layer with the electroluminescent layer addressing the **control means of the bistable element** associated with said electroluminescent cell.

10. Image display device according to any one of the preceding claims, **characterized in that**, in said panel, all the column electrodes (Xₚ) of the first array are interlinked at the same potential.

## Patentansprüche

1. Bildanzeigevorrichtung, die einen bistabilen Elektrolumineszenzbildschirm zum Anzeigen von Bildern, die in Teilbilder geteilt sind, umfasst, wobei der Bildschirm Folgendes auf einem Substrat (1) angeordnet umfasst:
- eine Anordnung von in Zeilen und Spalten verteilten Elektrolumineszenzzellen (C_{n,p}) und eine Anordnung bistabiler Elemente (B_{n,p}), die von einem hochimpedanten ausgeschalteten Zustand in einen niederimpedanten eingeschalteten Zustand und umgekehrt geschaltet werden können, wobei jedes bistabile Element (B_{n,p}) einer Elektrolumineszenzzelle (C_{n,p}) zugeordnet ist und mit Steuermitteln versehen ist,
- eine erste Anordnung von Spaltenelektroden (Xₚ) für die Leistungsversorgung der Zellen (C_{n,p}) und eine zweite Anordnung von Zeilenelektroden (Yₙ),
- eine dritte Anordnung von Spaltenelektroden (Aₚ) zum Adressieren der Zellen (C_{n,p}),
in der jede Elektrolumineszenzzelle (C_{n,p}) mit dem bistabilen Element (B_{n,p}), dem sie zugeordnet ist, elektrisch in Reihe verknüpft ist, wobei die Reihe zwischen eine Spaltenelektrode (Xₚ) der ersten Anordnung und eine Zeilenelektrode (Yₙ) der zweiten Anordnung geschaltet ist, wobei die Bildanzeigevorrichtung außerdem Mittel zum Steuern der Elektroden (10, 11) umfasst,
**dadurch gekennzeichnet, dass**:
- die einer Elektrolumineszenzzelle (C_{n,p}) zugeordneten Mittel zum Steuern jedes bistabilen Elements (B_{n,p}) zwischen eine Elektrode (Aₚ) der dritten Anordnung und die Elektrode (Yₙ) der zweiten Anordnung, die mit der Reihe, die dieses bistabile Element mit seiner zugeordneten Elektrolumineszenzzelle verknüpft, verbunden ist, geschaltet sind, wobei die Elektrode (Yₙ) der zweiten Anordnung somit sowohl zur Adressierung als auch zur Leistungsversorgung verwendet wird;
- die Mittel zum Steuern der Elektroden (10, 11) zum Ansteuern des Bildschirms nur unter Verwendung der ersten, der zweiten und der dritten Anordnung von Elektroden ausgelegt sind.

2. Bildanzeigevorrichtung nach Anspruch 1, **dadurch gekennzeichnet, dass** die Mittel zum Steuern der Elektroden (10, 11) so ausgelegt sind, dass während jedes Teilbilds eines anzuzeigenden Bilds eine Auswahlphase für jede Zeile von Elektrolumineszenzzellen (C_{n,p}) und eine nachfolgende Wartungsphase stattfinden, wobei jede Auswahlphase einer Reihe von Lumineszenzzellen eine Löschoperation, gefolgt von einer Schreiboperation, in der Weise umfasst, dass irgendeine Löschoperation dafür ausgelegt ist, alle bistabilen Elemente der Zellen (C_{n,p}) dieser Zeile in den hochimpedanten ausgeschalteten Zustand zu schalten, ohne dass der Zustand der den Zellen der anderen Zeilen zugeordneten bistabilen Elemente beeinflusst wird, und dass irgendeine folgende Schreiboperation dieser Zeile von Zellen (C_{n,p}) dafür ausgelegt ist, die den Elektrolumineszenzzellen (C_{n,p}) dieser Zeile zugeordneten bistabilen Elemente, die aktiviert werden müssen, um das Bild des gegenwärtigen Einzelbilds anzuzeigen, in den niederimpedanten eingeschalteten Zustand zu schalten und den hochimpedanten ausgeschalteten Zustand der den anderen Zellen (C_{n,p}) dieser Zeile zugeordneten bistabilen Elemente, die nicht aktiviert werden sollen, um das Bild des gegenwärtigen Teilbilds anzuzeigen, aufrechtzuerhalten, ohne dass der eingeschaltete oder ausgeschaltete Zustand der bistabilen Elemente (C_{n,p}) der Zellen der anderen Zeilen beeinflusst wird.

3. Bildanzeigevorrichtung nach Anspruch 2, **dadurch gekennzeichnet, dass** die Mittel zum Steuern der Elektroden (10, 11) dafür ausgelegt sind, um die bistabilen Elemente, die den Elektrolumineszenzzellen (C_{n,p}) einer ausgewählten Zeile zugeordnet sind, in den niederimpedanten eingeschalteten Zustand zu schalten und den hochimpedanten ausgeschalteten Zustand der bistabilen Elemente, die den anderen Elektrolumineszenzzellen (C_{n,p}) dieser Zeile zugeordnet sind, aufrechtzuerhalten, an die Elektrode (Yₙ) dieser ausgewählten Zeile eine Spannung V_{L} mit negativer Amplitude anzulegen, an die Elektroden der nicht ausgewählten Zeilen gleichzeitig eine Spannung null anzulegen, an die Spaltenelektroden (Xₚ) der ersten Anordnung gleichzeitig eine Spannung V_{S} anzulegen, an die Elektroden (Aₚ) der dritten Anordnung, die zum Adressieren der Zellen (C_{n,p}) verwendet werden, die mit der Elektrode (Yₙ) dieser ausgewählten Zeile verknüpft sind und die aktiviert werden sollen, gleichzeitig eine Spannung V_{S} + V_{ON} anzulegen, an die Elektroden (Aₚ) der dritten Anordnung, die zum Adressieren der Elektrolumineszenzzellen (C_{n,p}) verwendet werden, die mit der Elektrode (Yₙ) dieser ausgewählten Zeile verknüpft sind und die nicht aktiviert werden sollen, gleichzeitig eine Spannung V_{S} anzulegen, wobei, falls V_{D} die Spannung ist, die die Emission einer Elektrolumineszenzzelle (C_{n,p}) auslöst, und falls V_{Z} die kritische Spannung eines bistabilen Elements (B_{n,p}) ist:
- diese Elektrolumineszenzzelle unter einer zwischen dieser Elektrolumineszenzzelle (C_{n,p}) und diesem bistabilen Element (B_{n,p}) in Reihe angelegten Spannung V_{D} ausschaltet;
- diese Elektrolumineszenzzelle über einer zwischen dieser Elektrolumineszenzzelle (C_{n,p}) und diesem bistabilen Element (B_{n,p}) in Reihe angelegten Spannung V_{D} + V_{Z} einschaltet;
sich der eingeschaltete oder ausgeschaltete Zustand dieser Zelle für eine zwischen dieser Elektrolumineszenzzelle (C_{n,p}) und diesem bistabilen Element (B_{n,p}) angelegte Spannung zwischen V_{D} und V_{D} + V_{Z} nicht ändert, V_{S}, V_{L} und V_{ON} in der Weise gewählt sind, dass:
- V_{D} < V_{S} < V_{D} + V_{Z} und V_{D} < V_{S} + V_{ON} < V_{D} + V_{Z} ist,
- V_{S} + V_{L} + V_{ON} > V_{D} + V_{Z} ist.

4. Bildanzeigevorrichtung nach einem der vorhergehenden Ansprüche, **dadurch gekennzeichnet, dass** die Elektroden (Aₚ) der dritten Anordnung in dem Bildschirm schmaler als die Spaltenelektroden (Xₚ) der ersten Anordnung sind.

5. Bildanzeigevorrichtung nach einem der vorhergehenden Ansprüche, **dadurch gekennzeichnet, dass** die Elektroden (Aₚ) der dritten Anordnung in dem Bildschirm mindestens zweimal schmaler als die Elektroden (Xₚ, Yₙ) der ersten Anordnung und der zweiten Anordnung sind.

6. Bildanzeigevorrichtung nach einem der vorhergehenden Ansprüche, **dadurch gekennzeichnet, dass** jede Elektrolumineszenzzelle (C_{n,p}) in dem Bildschirm mit dem bistabilen Element (B_{n,p}), das ihm zugeordnet ist, unter Verwendung einer Elektrode, die eine Zwischenschicht (3) bildet, in Reihe verknüpft ist.

7. Bildanzeigevorrichtung nach Anspruch 6, **dadurch gekennzeichnet, dass** die Zwischenschicht (3) in dem Bildschirm durchsichtig oder teildurchsichtig ist und dass das dieser Zelle (C_{n,p}) zugeordnete bistabile Element (B_{n,p}) eine photoleitende Schicht (2; 2') umfasst, die zwischen der Zwischenschicht (3) und der mit dieser Zelle (C_{n,p}) verknüpften Elektrode (Xₚ) der ersten Anordnung eingefügt ist.

8. Bildanzeigevorrichtung nach Anspruch 5, **dadurch gekennzeichnet, dass** die Mittel zum Steuern des zugeordneten bistabilen Elements (B_{n,p}) für jede Elektrolumineszenzzelle (C_{n,p}) des Bildschirms eine Adressierungselektrolumineszenzschicht (4; 5) umfassen, die zwischen der zum Adressieren der Zelle verwendeten Elektrode (Aₚ) der dritten Anordnung und der mit der Zelle (C_{n,p}) verknüpften Zeilenelektrode (Yₙ) der zweiten Anordnung eingefügt ist und die mit der photoleitenden Schicht (2; 2') des bistabilen Elements (B_{n,p}) optisch gekoppelt ist.

9. Bildanzeigevorrichtung nach Anspruch 8, **dadurch gekennzeichnet, dass** jede Elektrolumineszenzzelle (C_{n,p}) in dem Bildschirm eine Hauptelektrolumineszenzschicht (4) umfasst, die mit der Elektrolumineszenzschicht, die das Steuermittel des der Elektrolumineszenzzelle zugeordneten bistabilen Elements adressiert, ein und dieselbe Schicht bildet.

10. Bildanzeigevorrichtung nach einem der vorhergehenden Ansprüche, **dadurch gekennzeichnet, dass** alle Spaltenelektroden (Xₚ) der ersten Anordnung in dem Bildschirm auf demselben Potential miteinander verknüpft sind.

## Revendications

1. Dispositif de visualisation d'images comprenant un panneau électroluminescent bistable pour la visualisation d'images divisées en sous-trames, ledit panneau comprenant, disposés sur un substrat (1) :
- un réseau de cellules électroluminescentes (C_{n,p}) distribuées en lignes et en colonnes, et un réseau d'éléments bistables (B_{n,p}) qui peuvent basculer d'un état de haute impédance OFF à un état de basse impédance ON et vice-versa, où chaque élément bistable (B_{n,p}) est associé à une cellule électroluminescente (C_{n,p}) et est doté de moyens de commande,
- un premier réseau d'électrodes de colonnes (Xₚ) servant à l'alimentation desdites cellules (C_{n,p}) et un second réseau d'électrodes de lignes (Yₙ),
- un troisième réseau d'électrodes de colonne (Aₚ) pour l'adressage desdites cellules (C_{n,p}),
dans lequel chaque cellule électroluminescente (C_{n,p}) est reliée en série avec l'élément bistable (B_{n,p}) qui lui est associé, ladite série étant connectée entre une électrode de colonne (Xₚ) du premier réseau et une électrode de ligne (Yₙ) du second réseau,
ledit dispositif de visualisation d'images comprenant également des moyens de contrôle desdites électrodes (10, 11),
**caractérisé en ce que** :
- les moyens de contrôle de chaque élément bistable (B_{n,p}) associé à une cellule électroluminescente (C_{n,p}) sont connectés entre une électrode (Aₚ) du troisième réseau et l'électrode (Yₙ) du second réseau connectant la série reliant cet élément bistable avec sa cellule électroluminescente associée, l'électrode (Yₙ) dudit second réseau étant alors utilisée à la fois pour l'adressage et l'alimentation ;
- les moyens de contrôle des électrodes (10, 11) sont adaptés pour le pilotage dudit panneau en utilisant seulement les premier, second et troisième réseaux d'électrodes.

2. Dispositif de visualisation d'images selon la revendication 1 **caractérisé en ce que** les moyens de contrôle des électrodes (10, 11) sont adaptés de telle manière que, durant chaque sous-trame d'une image à visualiser, prennent place une phase de sélection pour chaque ligne de cellules électroluminescentes (C_{n,p}) et une subséquente phase de maintien, où chaque phase de sélection d'une ligne de cellules électroluminescentes comprend une opération d'effaçage suivi d'une opération d'écriture, telles que chaque opération d'effaçage est conçue pour basculer à l'état de haute impédance OFF tous les éléments bistables des cellules C_{n,p} de cette ligne sans affecter l'état des éléments bistables associés aux cellules des autres lignes et telles que chaque opération d'écriture de cette ligne de cellules (C_{n,p}) est conçue pour basculer à l'état de basse impédance ON les éléments bistables des cellules électroluminescentes (C_{n,p}) de cette ligne qui doivent être activés pour visualiser l'image de la sous-trame courante, et pour maintenir à l'état de haute impédance OFF les éléments bistables associés avec les autres cellules (C_{n,p}) de cette ligne qui ne doivent pas être activés pour visualiser l'image de la sous-trame courante, sans affecter les états ON ou OFF des éléments bistables (C_{n,p}) des cellules des autres lignes.

3. Dispositif de visualisation d'images selon la revendication 2 **caractérisé en ce que**, pour basculer à l'état de basse impédance ON les éléments bistables associés aux cellules électroluminescentes (C_{n,p}) d'une ligne sélectionnée et pour maintenir l'état de haute impédance OFF les éléments bistables associés aux autres cellules électroluminescentes (C_{n,p}) de cette ligne, les moyens de contrôle des électrodes (10, 11) sont adaptés pour appliquer une tension d'amplitude négative V_{L} à cette électrode de ligne sélectionnée (Yₙ), pour appliquer simultanément une tension nulle aux électrodes de ligne non sélectionnées du second réseau, pour appliquer simultanément une tension V_{S} aux électrodes de colonne (Xₚ) du premier réseau, pour appliquer simultanément une tension V_{S} + V_{ON} aux électrodes (Aₚ) du troisième réseau utilisé pour l'adressage des cellules (C_{n,p}) qui sont reliées à cette électrode de ligne sélectionnée (Yₙ) et qui sont à activer, pour appliquer simultanément une tension V_{S} aux électrodes (Aₚ) du troisième réseau utilisé pour l'adressage des cellules électroluminescentes C_{n,p} qui sont reliées à cette électrode de ligne sélectionnée (Yₙ) et qui ne sont pas à activer, où, si V_{D} est la tension de déclenchement d'une cellule électroluminescente (C_{n,p}) et si V_{Z} la tension critique d'un élément bistable (B_{n,p}) telles que :
- en deçà d'une tension V_{D} appliquée entre cette cellule électroluminescente (C_{n,p}) et cet élément bistable (B_{n,p}) en série, cette cellule électroluminescente s'éteint ;
- au delà d'une tension V_{D}+V_{Z} appliquée entre cette cellule électroluminescente (C_{n,p}) et cet élément bistable (B_{n,p}) en série, cette cellule s'allume ;
- pour une tension comprise entre V_{D} et V_{D}+V_{Z} appliquée entre cette cellule électroluminescente (C_{n,p}) et cet élément bistable (B_{n,p}), l'état de la cellule ON ou OFF ne change pas,
V_{S}, V_{L} et V_{ON} sont choisies pour que :
- V_{D} < V_{S}< V_{D}+V_{Z} et V_{D} < V_{S}+V_{ON} < V_{D}+V_{Z}
- V_{S}+V_{L}+V_{ON} > V_{D}+V_{Z}

4. Dispositif de visualisation d'images selon l'une quelconque des revendications précédentes **caractérisé en ce que**, dans ledit panneau, les électrodes (Aₚ) du troisième réseau sont moins larges que les électrodes de colonne (Xₚ) du premier réseau.

5. Dispositif de visualisation d'images selon l'une quelconque des revendications précédentes **caractérisé en ce que**, dans ledit panneau, les électrodes (Aₚ) du troisième réseau sont au moins deux fois moins larges que les électrodes (Xₚ,Yₙ) du premier réseau et du second réseau.

6. Dispositif de visualisation d'images selon l'une quelconque des revendications précédentes **caractérisé en ce que**, dans ledit panneau, chaque cellule électroluminescente (C_{n,p}) est reliée en série avec l'élément bistable (B_{n,p}) qui lui est associé à l'aide d'une électrode intermédiaire (3).

7. Dispositif de visualisation d'images selon la revendication 6 **caractérisé en ce que**, dans ledit panneau, ladite électrode intermédiaire (3) est transparente ou semi-transparente et l'élément bistable (B_{n,p}) associé à cette cellule (C_{n,p}) comprend une couche photoconductrice (2; 2') qui est intercalée entre ladite électrode intermédiaire (3) et l'électrode (Xₚ) du premier réseau relié à cette cellule (C_{n,p}).

8. Dispositif de visualisation d'images selon la revendication 5 **caractérisé en ce que**, pour chaque cellule électroluminescente (C_{n,p}) dudit panneau, les moyens de commande de l'élément bistable (B_{n,p}) associé comprennent une couche électroluminescente d'adressage (4; 5) qui est intercalée entre l'électrode (Aₚ) du troisième réseau utilisé pour l'adressage de ladite cellule et l'électrode de ligne (Yₙ) du second réseau relié à ladite cellule (C_{n,p}) et qui est couplée optiquement avec la couche photoconductrice (2; 2') dudit élément bistable (B_{n,p}).

9. Dispositif de visualisation d'images selon la revendication 8 **caractérisé en ce que**, dans ledit panneau, chaque cellule électroluminescente (C_{n,p}) comprend une couche électroluminescente principale (4) qui forme une seule et même couche avec la couche électroluminescente d'adressage des moyens de commande de l'élément bistable de ladite cellule.

10. Dispositif de visualisation d'images selon l'une quelconque des revendications précédentes **caractérisé en ce que**, dans ledit panneau, toutes les électrodes (Xₚ) du premier réseau sont reliées entre elles au même potentiel.
